Europäisches Patentamt

European Patent Office

Office européen des brevets

(11) Numéro de publication: **0 387 746**

**A1**

(12) # DEMANDE DE BREVET EUROPEEN

(21) Numéro de dépôt: **90104619.3**

(22) Date de dépôt: **12.03.90**

(51) Int. Cl.⁵: **H03B 5/18**

(30) Priorité: **15.03.89 FR 8903411**

(43) Date de publication de la demande:
**19.09.90 Bulletin 90/38**

(84) Etats contractants désignés:
**CH DE ES FR GB IT LI NL SE**

(71) Demandeur: **ALCATEL TRANSMISSION PAR FAISCEAUX HERTZIENS A.T.F.H.**
**55, rue Greffulhe**
**F-92301 Levallois-Perret Cédex(FR)**

(84) **DE ES FR GB IT NL SE**

Demandeur: **ALCATEL N.V.**
**Strawinskylaan 341**
**NL-1077 XX Amsterdam(NL)**

(84) **CH LI**

(72) Inventeur: **Martheli, Michel**
**14bis, rue des Blanchards**
**F-95000 Jouy Le Moutier(FR)**

(74) Mandataire: **Weinmiller, Jürgen et al**
**Lennéstrasse 9 Postfach 24**
**D-8133 Feldafing(DE)**

(54) **Oscillateur hyperfréquence à transistor.**

(57) Oscillateur hyperfréquence à au moins un transistor (1), bipolaire ou non.

Dans le circuit d'émetteur (ou de source pour un transistor FET) de ce transistor (1) est placé un circuit réactif accordable (13, 15, 16) apte à régler la zone d'instabilité potentielle du transistor. Ce circuit comporte un tronçon de ligne série (13) et une capacité parallèle (15, 16) dont au moins une partie est constituée par un pavé conducteur (15) de dimensions ajustables.

EP 0 387 746 A1

## OSCILLATEUR HYPERFREQUENCE A TRANSISTOR

La présente invention se rapporte à un oscillateur hyperfréquence à au moins un transistor, bipolaire ou non.

La plupart des oscillateurs hyperfréquence à transistor, bipolaire ou à effet de champ, actuellement réalisés, notamment ceux dont le circuit d'accord vient agir sur la base du transistor, sont munis d'un circuit de polarisation où le collecteur, ou le drain, est directement relié à la masse (voir par exemple les documents US-A-4.684.904 et US-A-4.736.169). Celà a pour conséquence de créer au niveau du transistor une instabilité potentielle qui est directement liée au transistor, et donc non contrôlée. Il en résulte fréquemment des oscillations parasites ainsi que des accrochages en basse fréquence.

Pour produire une oscillation dans une bande de fréquence imposée, on est souvent obligé de prévoir, en sortie de l'oscillateur, un transformateur d'impédance en ligne quart d'onde, ce qui est non seulement assez encombrant, mais qui oblige de surcroît à s'imposer une impédance de sortie bien définie.

L'invention vise à remédier à ces inconvénients. Elle se rapporte à cet effet à un oscillateur hyperfréquence à au moins un transistor, bipolaire ou non, dont le circuit de polarisation comporte, dans son circuit d'électrode d'émetteur pour un transistor bipolaire ou dans son circuit d'électrode de source pour un transistor du genre FET, un circuit réactif accordable composé d'un tronçon de ligne placé en série dans le circuit de polarisation et d'une capacité branchée en parallèle, du point de vue radio-fréquence, entre cette électrode et la masse.

L'invention sera bien comprise, et ses avantages et autres caractéristiques ressortiront, lors de la description de cet oscillateur, en référence au dessin schématique annexé dans lequel :

- Figure 1 est un schéma électrique de cet oscillateur ; et

- Figure 2 montre le mode de réalisation de la capacité accordable placée dans le circuit d'émetteur du transistor.

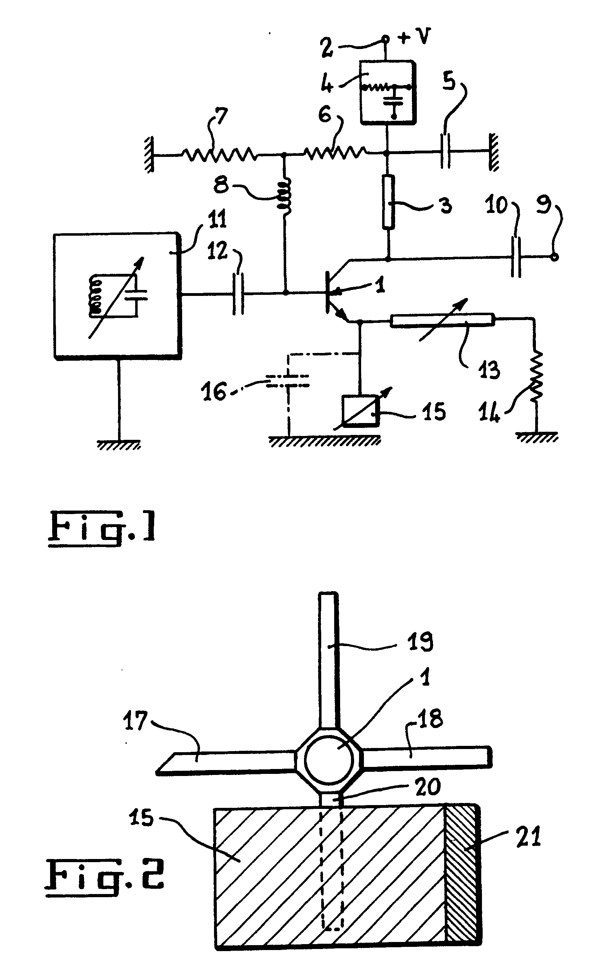

En se reportant à la figure 1, la référence 1 désigne le transistor bipolaire de cet oscillateur hyperfréquence. Ce transistor est dans cet exemple de type NPN, et est par exemple un transistor disponible dans le commerce sous la référence NE 85635.

Le collecteur de ce transistor 1 est relié à la borne 2 de la tension continue d'alimentation +V par l'intermédiaire d'une longueur de ligne 3, de haute impédance en radio-fréquence, et d'un circuit 4 de découplage basse-fréquence. Une capacité 5, qui est branchée entre le point de jonction du circuit 4 et du tronçon de ligne 3 et la masse, assure le découplage en radio-fréquence de la tension continue +V.

Entre ce même point de jonction et la masse est branché un pont de résistances 6, 7, qui fournit la polarisation de la base du transistor 1 à travers une self de choke 8. Le collecteur du transistor 1 est relié à la borne de sortie 9 de l'oscillateur par l'intermédiaire d'une capacité de liaison radio-fréquence 10.

De manière très classique, la base du transistor 1 est reliée au circuit d'accord 11 de l'oscillateur par l'intermédiaire d'une capacité de liaison 12 radio-fréquence de forte valeur (par exemple de quelques dizaines de picofarads).

Conformément à l'invention, la fréquence et la largeur de la bande pour lesquelles le transistor 1 est potentiellement instable, sont sélectionnées par l'insertion dans son circuit d'émetteur d'un circuit réactif accordable comportant :

. un tronçon de ligne ajustable 13, de forte impédance en radio-fréquence, qui est branchée entre l'émetteur et la masse, en série avec une résistance de polarisation 14 ;

. une capacité ajustable 15, de très faible valeur, qui est branchée entre cet émetteur et la masse ; en technique de réalisation microruban ("microstrip"), cette capacité ajustable est réalisée sous la forme d'un "pavé" conducteur de dimensions ajustables.

Augmenter les dimensions du pavé 15 ou allonger le tronçon de ligne 13 revient à diminuer les valeurs des fréquences pour lesquelles le transistor est potentiellement instable, et donc celles pour lesquelles l'oscillateur, peut fonctionner sans risques d'accrochages parasites.

A noter que, dans le cas où la valeur de cette capacité accordable doit être relativement élevée, il convient de brancher une capacité discrète 16, par exemple un condensateur "chips", en parallèle sur le pavé ajustable 15.

La figure 2 montre comment est réalisée, en technique microruban, la faible capacité ajustable 15.

Le transistor 1, qui est représenté en vue de dessus, comporte quatre sorties de connexion, réalisées en microruban.

. une sortie 17 de connexion de base

. une sortie 18 de connexion de collecteur

. deux sorties 19 et 20 de connexion d'émetteur, qui sont reliées électriquement entre elles dans la "puce" qui constitue le transistor 1.

La sortie d'émetteur 20 est soudée à un "pavé" 15, c'est à dire une fine plaque conductrice réalisée en technique microruban. Etant donné qu'il est séparé du plan de masse par la couche isolante que constitue le substrat, ce pavé 15 forme avec ce plan de masse une capacité de très faible valeur qui est branchée entre l'émetteur du transistor 1 et la masse.

La valeur de cette capacité 15 est avantageusement ajustée en agrandissant les dimensions du pavé 15 au moyen de traits d'encre conductrice 21.

Comme il va de soi, l'invention n'est pas limitée à l'exemple de réalisation qui vient d'être décrit. Par exemple, la sortie radio fréquence 9 pourrait être prise sur une autre électrode que le collecteur. Au lieu d'utiliser un transistor bipolaire, on pourrait aussi bien utiliser un transistor du type FET (transistor à effet de champ) : dans un tel cas, le circuit réactif accordable 13, 15 serait inséré dans son circuit d'électrode de source. L'invention s'applique bien évidemment à toutes les sortes d'oscillateurs hyperfréquence, qu'ils soient commandables en tension (VCO) ou non et, s'ils s'agit d'oscillateurs commandables en tension (VCO), qu'il soient à double-pente ou non.

**Revendications**

1 - Oscillateur hyperfréquence à au moins un transitor (1), caractérisé en ce que le circuit de polarisation de ce transistor comporte, dans le circuit d'émetteur pour un transistor bipolaire ou dans le circuit de source pour un transistor du genre FET, un circuit réactif accordable (13, 15, 16) apte à régler la zone d'instabilité potentielle du transistor, ce circuit réactif accordable étant composé d'un tronçon de ligne (13) placé en série dans le circuit de polarisation (13, 14) et d'une capacité (15, 16) branchée en parallèle, du point de vue radio-fréquence, entre l'électrode d'émetteur ou de source de ce transistor (1) et la masse.

2 - Oscillateur hyperfréquence selon la revendication 1, caractérisé en ce que cette capacité comporte un pavé conducteur (15) dont les dimensions sont ajustables.

3 - Oscillateur hyperfréquence selon la revendication 2, caractérisé en ce que cette capacité comporte en outre un condensateur discret (16) qui est branché en parallèle sur ce pavé conducteur (15).

Fig.1

Fig.2

Office européen
des brevets

# RAPPORT DE RECHERCHE EUROPEENNE

Numero de la demande

EP 90 10 4619

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| A | US-A-4 758 804 (INOE et al.) <br> * En entier * <br> --- | 1 | H 03 B 5/18 |
| A | US-A-4 639 690 (LEWIS) <br> * Résumé * <br> --- | 3 | |
| D,A | US-A-4 736 454 (HIRSCH) <br> --- | | |
| D,A | US-A-4 684 904 (WATKINS et al.) <br> ----- | | |

DOMAINES TECHNIQUES RECHERCHES (Int. Cl.5)

H 03 B

Le présent rapport a été établi pour toutes les revendications

| Lieu de la recherche | Date d'achèvement de la recherche | Examinateur |
|---|---|---|
| LA HAYE | 20-06-1990 | PEETERS M.M.G. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0403)